# EUROPÄISCHE PATENTANMELDUNG

(11) **EP 4 340 005 A1**
(43) Veröffentlichungstag der Anmeldung: **20.03.2024**
(21) Anmeldenummer: 22196286.3
(22) Anmeldetag: 19.09.2022
(51) Int. Cl.: H01L 21/56, H01L 23/16

(54) **UNTERFÜLLTES ELEKTRONIKMODUL MIT FLIESSRICHTUNGSLEITSTRUKTUREN**

(71) Anmelder: Siemens Aktiengesellschaft, 80333 München (DE)
(72) Erfinder: Heimann, Matthias, 14469 Potsdam (DE); Müller, Bernd, 16259 Falkenberg (DE); Nachtigall-Schellenberg, Christian, 14480 Potsdam (DE); Radüge, Christian, 90425 Nürnberg (DE); Stencel, Lisa, 10553 Berlin (DE); Strogies, Jörg, 14163 Berlin (DE); Wilke, Klaus, 12527 Berlin (DE); Woiton, Michael, 90425 Nürnberg (DE)
(74) Vertreter: Siemens Patent Attorneys

(57) **Zusammenfassung**

Die Erfindung betrifft ein elektronisches Modul (100) aufweisend zumindest ein erstes Substrat (10), ein zweites Substrat (20) und zwischen dem ersten und dem zweiten Substrat (10,20) angeordnete Halbleiterbauteile (30), die an das erste Substrat (10) und an das zweite Substrat (20) gefügt sind, ferner aufweisend eine Unterfüllung (50), die einen Spalt (40) zwischen den Halbleiterbauteilen (30) und Substraten (10, 20) zumindest teilweise ausfüllt und Strukturelemente (60,...,65), die im Spalt (40) angeordnet und zumindest teilweise von der Unterfüllung (50) umgeben sind.

## Beschreibung

Die Erfindung betrifft ein elektronisches Modul sowie ein Verfahren zum Einbringen von Unterfüllung in ein elektronisches Modul

Der Erfindung liegen Unterfüllungen für Kapillarfluss-Underfill-Applikationen zugrunde. Diese Unterfüllungen (im Englischen "underfill") müssen in den Zielapplikationen mit möglichst kurzer Prozesszeit fehlerarm appliziert werden. Diese Forderung resultiert primär aus thermomechanischen Erfordernissen und zunehmend auch Isolationseigenschaften, insbesondere bei stark miniaturisierten leistungselektronischen Aufbauten. Erforderlich ist im Besonderen die vollständige Unterfüllung ohne eingeschlossene Blasen an kritischen Stellen durch eingeschlossene Luft oder Ausgasungen aus den Materialien bzw. unvollständig durch den Spalt getriebene Fließfronten des Underfill.

Der Erfindung liegt die Aufgabe zugrunde Unterfüllungen zu verbessern.

Diese Aufgabe wird durch ein elektronisches Modul mit den im Anspruch 1 angegebenen Merkmalen gelöst. Das elektronische Modul weist dabei zumindest ein erstes Substrat, ein zweites Substrat und zwischen dem ersten und dem zweiten Substrat angeordnete Halbleiterbauteile auf. Die Halbleiterbauteile sind dabei an das erste und das zweite Substrat gefügt. Derartige elektronische Module können insbesondere leistungselektronische Module sein, in denen ungehäuste Chips verbaut sind. Aus Isolations- und Stabilitätsgründen wird in solche elektronischen Module Unterfüllungsmaterial eingebracht, das im Folgenden einfach als Unterfüllung bezeichnet ist. Im Englischen wird die Unterfüllung als Underfill bezeichnet. Das erste Substrat, das zweite Substrat und die Halbleiterbauteile bilden dabei einen Spalt aus, der mit der Unterfüllung ausgefüllt ist. Die Unterfüllung füllt dabei den Spalt zumindest teilweise, insbesondere vollständig aus und umgibt dabei vorzugsweise die Halbleiterbauteile vollständig. Weiterhin sind im Spalt Strukturelemente angeordnet, die zumindest teilweise von der Umfüllung umgeben sind. Die Strukturelemente dienen dabei dazu, die Unterfüllung während des Fertigungsprozesses zu leiten und möglichst blasenfrei in den Spalt einzubringen. Die Strukturelemente verbleiben dabei im elektronischen Modul. Die Unterfüllung füllt den Spalt dabei vorzugsweise vollständig, zumindest bei Vernachlässigung der stark verringerten Lufteinschlüsse aus.

In einer weiteren Ausführungsform sind die Strukturelemente bezüglich der Ebene der Substrate bogenförmig ausgestaltet. Die Form der Strukturelemente wird vorliegend bezüglich der Fließrichtung des Unterfüllmaterials angegeben. Die Form der Strukturelemente ist dabei parallel zu den Substraten zu verstehen, so wie die Fließrichtung der Unterfüllung auch parallel zu den Substraten verläuft. Senkrecht zu den Substraten sollten die Strukturelemente zumindest 50 % des Spalts ausfüllen, um einen unterfüllungsleitenden Effekt zu erreichen. Die Bogenform ist dabei an der Form von Venenklappen angelehnt und führt das noch flüssige Unterfüllungsmaterial in die gewünschten Richtungen.

In einer weiteren Ausführungsform beschreiben die Strukturelemente bezüglich der Ebene der Substrate höchstens ein Drittel eines Ellipsen- oder Kreisbogens. In anderen Worten umfasst der Ellipsen- oder Kreisbogen einen Winkel von maximal 120°, vorzugweise von maximal 100°. Diese Form hat sich als vorteilhaft erwiesen, um die Unterfüllung in flüssigem Zustand gut zu leiten und lehnt sich an die Form von Venenklappen an.

Eine weitere Ausführungsform weist zumindest zwei Paare von bogenförmig ausgestalteten Strukturelementen auf, deren Krümmung einander entgegengesetzt ist. So kann insbesondere bei mehreren Halbleiterbauteilen eine entsprechende Leitung der Unterfüllung sichergestellt werden. Vorteilhaft ist ein Paar von bogenförmig ausgestalteten Strukturelementen jeweils einem daran angeordneten Halbleiterbauteil zugeordnet. Die bogenförmig ausgestalteten Strukturelemente sind dabei vorzugsweise parallel angeordnet, sodass eine Verjüngung des Kanals, der sich zwischen den Paaren bildet, vermieden wird. Eine Verjüngung würde wiederum eine Veränderung der Fließgeschwindigkeit bedeuten und das Risiko von Ungleichverteilung der Unterfüllung bedeuten.

In einer weiteren Ausführungsform sind zumindest ein Teil der Strukturelemente zwischen Halbleiterbauteil und einer Kante eines der Substrate angeordnet. Der Spalt des elektronischen Moduls endet an den Kanten des bezüglich der Kante kürzeren oder kleineren der jeweiligen Substrate. Die Anordnung der Strukturelemente an den Kanten bzw. zwischen den Halbleiterbauteilen und den Kanten sorgt dafür, dass eine Leitung des flüssigen Unterfüllungsmaterials besonders gut geschieht. Eventuelle Lufteinschlüsse werden so aus dem Spalt herausgeführt.

In einer weiteren Ausführungsform sind pro Halbleiterbauteil mindestens zwei Strukturelemente angeordnet. Es hat sich gezeigt, dass eine gewisse Anzahl von Strukturelementen pro Halbleiterbauteil dazu führt, dass das Unterfüllungsmaterial besser verteilt wird und sich dementsprechend weniger Luftblasen bilden.

In einer weiteren Ausführungsform ist zumindest ein Strukturelement, das eine gerade Form aufweist, in einem Winkel von 30° bis 60° bezüglich einer Ecke eines Halbleiterbauteils angeordnet. Oftmals sind mehrere Halbleiterbauteile nebeneinander angeordnet und die Anordnung in einem Winkel bezüglich einer Ecke des Halbleiterbauteils trennt entsprechende Fließfronten zwischen den Halbleiterbauteilen und führt dazu, dass die Fließfronten dementsprechend getrennt bleiben und somit keine Blasenbildung durch zeitlich versetzte Fließfronten entsteht. Eine gerade Form kann dabei beispielsweise durch einen länglichen Quader realisiert werden.

Ergänzend oder alternativ kann zumindest ein weiteres gerades Strukturelement, in einem Winkel von 30° bis 60° bezüglich einer ersten Ecke und einer weiteren Ecke eines weiteren Halbleiterbauteils angeordnet sein.

In einer weiteren Ausführungsform ist zumindest ein Strukturelement zwischen zwei Halbleiterbauteilen angeordnet. Auch so können die Fließfronten entsprechend gesteuert werden. Zwischen den Halbleiterbauteilen bieten sich vor allem geradlinige Strukturelemente an.

In einer weiteren Ausführungsform sind die Strukturelemente als Metallisierung oder Lötstopplackausformung eines der Substrate ausgebildet. Dies ist insbesondere als Kupfermetallisierung mit der Fertigung der Substrate bereitstellbar. Weiterhin können Formteile als Strukturelemente bestückt werden.

neu In einer weiteren Ausführungsform sind die Strukturelemente als Formteil ausgebildet. Diese können einfach und effizient in bestehenden Bestückautomaten verarbeitet und bestückt werden.

In einer weiteren Ausführungsform sind die Strukturelemente aus einem Isolationsmaterial ausgebildet. Dies hat den Vorteil, dass diese besonders nah an den Halbleiterbauteilen bzw. an den kritischen Stellen der Halbleiterbauteile angeordnet werden können. Diese können aus Leiterplattenmaterial bzw. Substratmaterial bestehen oder als Formteile bestückt werden. Denkbar wären auch precoated Keramiken, z.B. zum Einkleben, als Strukturelemente.

In einer weiteren Ausführungsform sind die Strukturelemente aus einem Dammmaterial ausgebildet. Sogenannte hochviskose Dammmaterialien sind im üblichen Fertigungsprozess dispensbar und können so die Strukturelemente ausbilden. Dies hat den Vorteil, dass die Strukturelemente für jedes Design einzigartig einfach mit eingeplant und im Prozess aufgebracht werden können.

Die Aufgabe wird weiterhin durch ein Verfahren zum Einbringen einer Unterfüllung in einen Spalt eines elektronischen Moduls gelöst. Das elektronische Modul ist dabei gemäß einer der Ausführungsformen wie eingangs beschrieben ausgestaltet. Die Unterfüllung wird dabei in flüssiger Form an einer Kante oder Ecke eines der Substrate eingebracht. Ergänzend oder alternativ kann die Unterfüllung auch an einer Kante oder Ecke eines der Substrate eingebracht werden, die den Strukturelementen gegenüberliegt.

Im Folgenden wird die Erfindung anhand der in den Figuren dargestellten Ausführungsbeispiele näher beschrieben und erläutert. Es zeigen:
- FIG 1: einen Verlauf einer Unterfüllung in einem elektronischen Modul ohne Strukturelemente,
- FIG 2: den Verlauf aus FIG 1 zeitlich weiter fortgeschritten,
- FIG 3: einen Verlauf einer Unterfüllung in einem elektronischen Modul mit Strukturelementen,
- FIG 4: den Verlauf aus FIG 3 zeitlich weiter fortgeschritten,
- FIG 5: ein elektronisches Modul wie in FIG 3 und 4 im Querschnitt,
- FIG 6: einige Strukturelemente in einer Queransicht,
- FIG 7: eine ergänzende oder alternative Ausführungsform eines elektronischen Moduls,
- FIG 8: eine weitere Ausführungsform eines Moduls und
- FIG 9: eine Anordnung von Strukturelementen zum lokalen Einfangen von Blasen.

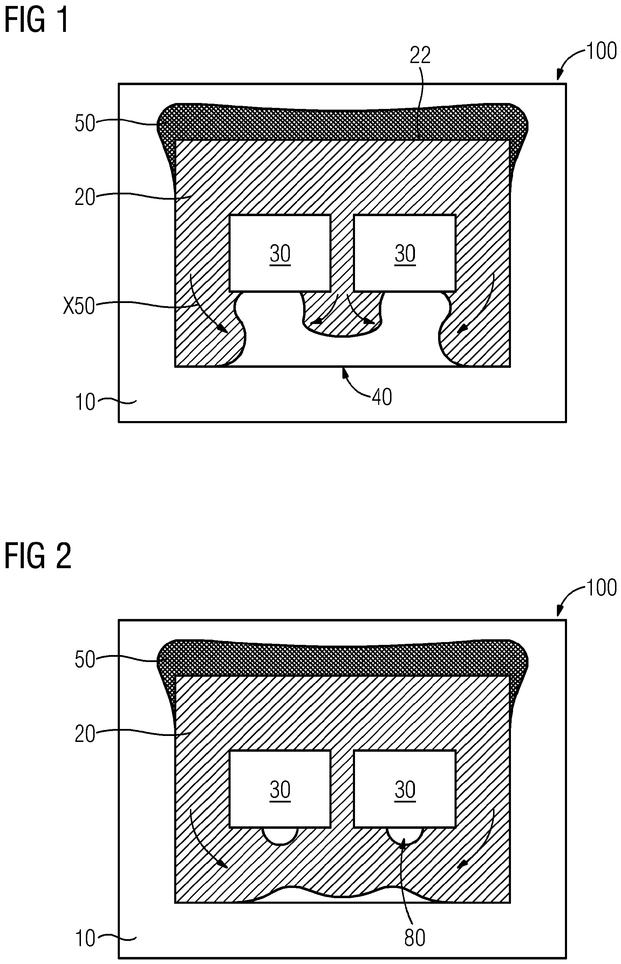

FIG 1 zeigt ein elektronisches Modul 100, mit zwei Halbleiterbauteilen 30, einem ersten Substrat 10 und einem zweiten Substrat 20 in der Draufsicht. Das zweite Substrat 20 ist dabei durchsichtig dargestellt, sodass ein Spalt 40 bzw. dessen Inhalt sichtbar ist. Die Unterfüllung 50 wurde an einer Kante 22 des zweiten Substrats 20 aufgebracht. Das hier zu sehende Dispensmuster ist ein sogenanntes I-Dispensmuster. Eine Flussrichtung X50 der Unterfüllung 50 ist zu sehen, ebenso wie ein Ausschnitt aus der Verteilung zum jeweiligen Zeitpunkt, wobei in FIG 1 die Unterfüllung noch nicht vollständig ausgebreitet ist.

FIG 2 zeigt analog zu FIG 1 und unter Verwendung derselben Bezugszeichen eine zeitlich weiter fortgeschrittene Ausbreitung der Unterfüllung 50, wobei sich ungünstigerweise Luftblasen 80 an den Halbleiterbauteilen 30 gebildet haben. Dies gilt es durch die Erfindung zu vermeiden.

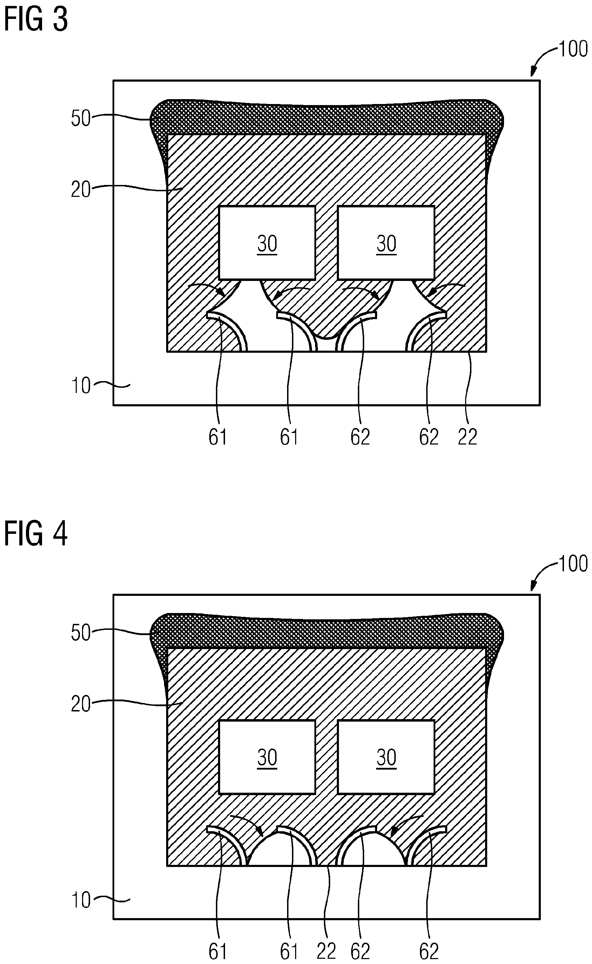

FIG 3 zeigt nun ein elektronisches Modul 100, wie es in den FIG 1 und 2 zu sehen ist, wobei hier bogenförmige Strukturelemente 61,62 eingebracht wurden, die die Unterfüllung 50 entsprechend leiten. Es hat sich gezeigt, dass die bogenförmigen Elemente 61,62 die Unterfüllung gut und gleichmäßig unter dem zweiten Substrat 20 herausleiten können, was dazu führt, dass sich kaum oder keine Blasen bilden. Es sind hierbei erste bogenförmige Strukturelemente 61 zu sehen, die eine Krümmung nach links aufweisen sowie zweite bogenförmige Strukturelemente 62, die eine Krümmung nach rechts aufweisen, wobei die ersten bogenförmigen Strukturelemente 61 als Paar ausgestaltet sind, die zwischen einem Halbleiter 30 und einer unmittelbar daran angrenzenden Kante 22 des zweiten Substrats 20 angeordnet sind. Analog sind die zweiten bogenförmigen Strukturelemente 62 angeordnet. Die Anordnung der bogenförmigen Strukturelemente an der Kante führen dazu, dass Luftblasen noch besser herausgetragen werden können.

FIG 4 zeigt nun zeitlich weiter fortgeschritten, dass die bogenförmigen Strukturelemente 61, 62 von Unterfüllung umspült werden und sich Luftblasen in Richtung der Kante 22 des zweiten Substrates 20 bewegen und letztendlich vollständig herausgespült werden können. Durch die entgegengesetzte Ausrichtung der beiden Paare von Strukturelementen 61,62 wird sichergestellt, dass die Unterfüllung 50 sich nicht kreuzt. Es können auch einzelne oder mehrere bogenförmige oder gekrümmte Strukturelemente 61,62 mit entgegengesetzter Krümmung angeordnet werden.

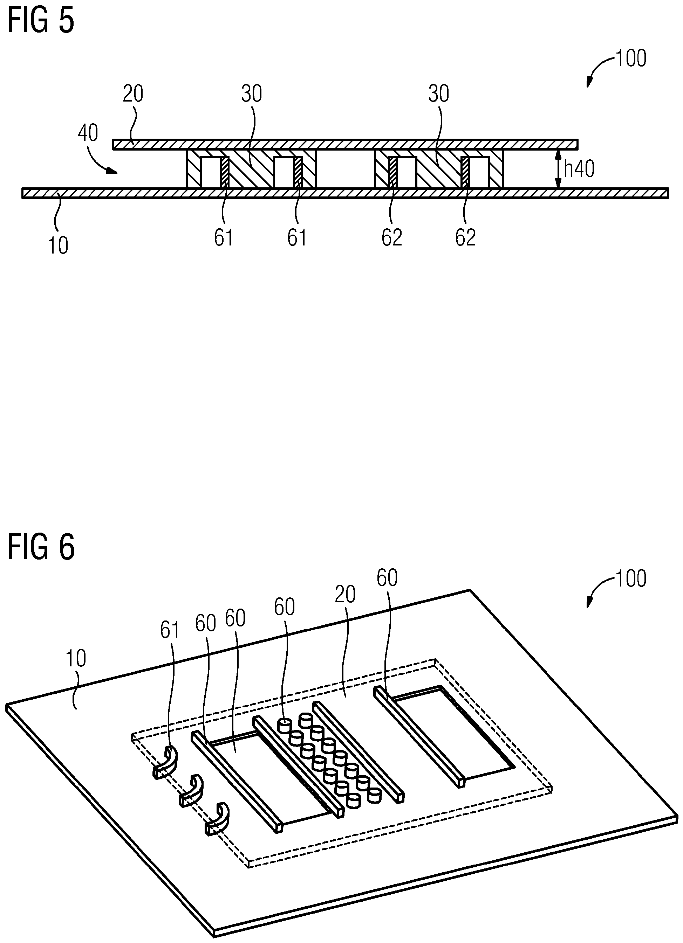

FIG 5 zeigt die Ausführungsform der FIG 3 und 4 im Querschnitt, wobei noch keine Unterfüllung eingebracht wurde. Hier ist zu sehen, dass im Vordergrund die bogenförmigen Strukturelemente 61, 62 angeordnet sind und im Hintergrund die Halbleiterbauteile 30 angeordnet sind. Der Spalt 40 weist dabei eine Höhe H40 auf. Die Strukturelemente 61, 62 haben dabei eine Höhe, die den Spalt nicht ganz ausfüllt. Erfahrungsgemäß sollten zumindest 50 %, insbesondere zumindest 70 % des Spaltes bzw. der Höhe H40 des Spaltes 40 durch die Strukturelemente 61,62 ausfüllt sein. Die Höhe der Strukturelemente gilt dabei auch für geradlinige Elemente. Hier ist nach ökonomischen Erwägungen die optimale Höhe bezüglich der Flusssteuerung zu wählen.

FIG 6 zeigt eine Schrägansicht eines elektronischen Moduls 100, das wieder ein transparentes zweites Substrat aufweist, damit die Strukturelemente zu sehen sind. Die bogenförmigen Strukturelemente 61, wie sie aus den vorherigen Figuren bekannt sind, sind zu sehen, weiterhin sind weitere Strukturelemente 60 zu sehen, beispielsweise kreisförmige oder geradlinige Strukturelemente. Ebenso führt eine Erniedrigung der Spalthöhe durch flächige Erhöhungen zu einer moderaten Verlangsamung. Auch Flusshindernisse wie z.B. eine Abfolge von Löt-Bumps mindert die Fließgeschwindigkeit. Umgekehrt führen Einsenkungen zu einer größeren Spalthöhe und beschleunigen auf diese Weise. Denkbar ist auch das Einfügen flächiger Schichten mit besonders niedrigem Kontaktwinkel, um die Fließgeschwindigkeit zu erhöhen.

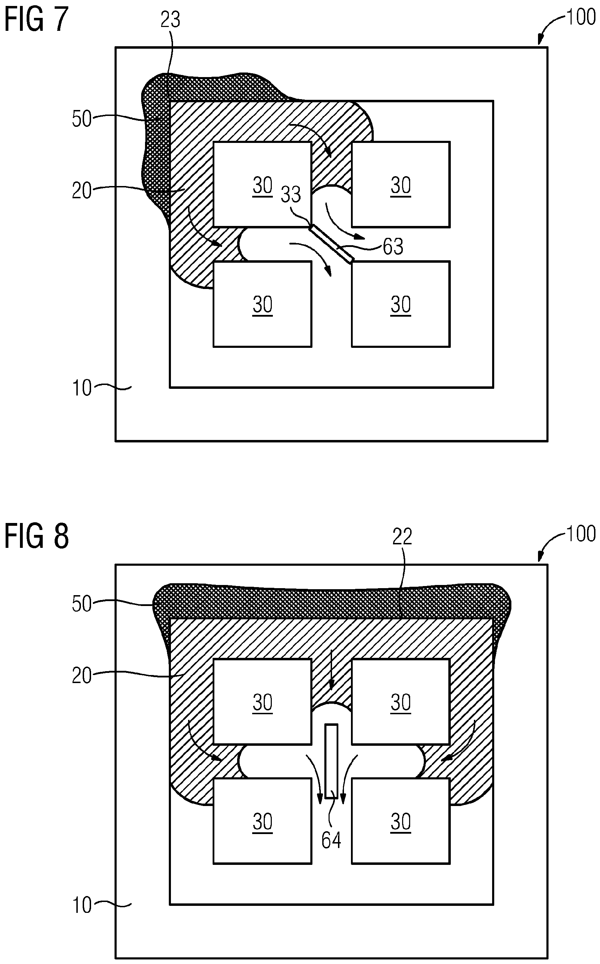

FIG 7 zeigt eine Ausführungsform, die ergänzend oder alternativ zu den bogenförmigen Strukturelementen 61,62 möglich ist.

Es ist ein elektronisches Modul 100 zu sehen, dass vier Halbleiterbauteile 30 aufweist, wobei für die Unterfüllung 50 ein L-Dispensmuster an einer Ecke 23 des zweiten Substrates 20 gewählt wurde. An einer Ecke 33 eines der Halbleiterbauteile 30 ist in einem 45°-Winkel ein längliches Strukturelement 63 angeordnet, das die Fließfronten der Unterfüllung vollständig voneinander trennt. So kann sichergestellt werden, dass die durch den Halbleiter zwangsweise getrennten Fließfronten zumindest bis zur Herausführung aus dem zweiten Substrat 20 getrennt bleiben und sich nicht durch Kreuzungen Lufteinschlüsse bilden.

FIG 8 zeigt eine ähnliche Ausführungsform wie FIG 7, wobei ein längliches Strukturelement 64 zwischen den Halbleiterbauteilen 30 angeordnet ist und ein I-Dispensmuster an einer Kante 22 des Substrats 20 gewählt wurde. Die so entstehenden drei Fließfronten werden zu zwei Fließfronten vereinigt, wobei das zwischen den Halbleiterbauteilen positionierte Strukturelement 64 dazu führt, dass sich im Wesentlichen aus den drei Fließfronten zwei Fließfronten vereinigen, weil eine der Fließfronten halbiert und den anderen zugeführt wird. Damit kann deren Neigung zu einer Blasenbildung dann deutlich verringert werden.

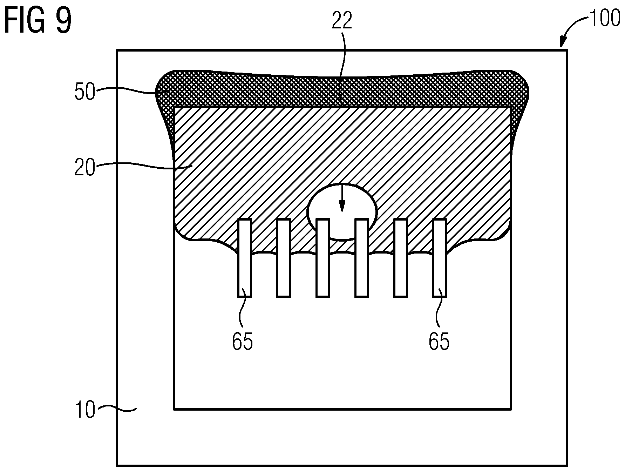

FIG 9 zeigt eine Anordnung von parallelen und geraden Strukturelementen 65, die so angeordnet sind, dass sie Luftblasen einfangen. Dies könnte beispielsweise unmittelbar an einer Kante 22 des zweiten Substrates sein, sodass beim Einbringen des Unterfüllungsmaterials entstehende Blasen direkt an den parallel angeordneten Strukturelementen 65 gefangen werden.

Zusammenfassend betrifft die Erfindung ein elektronisches Modul (100) aufweisend zumindest ein erstes Substrat (10), ein zweites Substrat (20) und zwischen dem ersten und dem zweiten Substrat (10,20) angeordnete Halbleiterbauteile (30), die an das erste Substrat (10) und an das zweite Substrat (20) gefügt sind. Weiterhin füllt eine Unterfüllung (50), einen Spalt (40) zwischen den Halbleiterbauteilen (30) und Substraten (10, 20) zumindest teilweise aus. Um die Unterfüllung zu verbessern, werden Strukturelemente (60, ..., 65) vorgeschlagen, die im Spalt (40) angeordnet und zumindest teilweise von der Unterfüllung (50) umgeben sind. Die Erfindung betrifft weiterhin ein Verfahren zum Einbringen von Unterfüllung (50) in ein elektronisches Modul (100).

### Bezugszeichen

- 100: elektronisches Modul
- 10: erstes Substrat
- 20: zweites Substrat
- 22: Kante des zweiten Substrats
- 23: Ecke des zweiten Substrats
- 30: Halbleiterbauteil
- 32: Kante des Halbleiterbauteils
- 33: Ecke des Halbleiterbauteils
- 40: Spalt
- h40: Höhe des Spalts
- 50: Unterfüllung
- X50: Flussrichtung der Unterfüllung
- 60: Strukturelemente
- 61,62: bogenförmige Strukturelemente
- 63,64,65: gerade Strukturelemente
- 80: Luftblase

## Patentansprüche

1. Elektronisches Modul (100) aufweisend zumindest ein erstes Substrat (10), ein zweites Substrat (20) und zwischen dem ersten und dem zweiten Substrat (10,20) angeordnete Halbleiterbauteile (30), die an das erste Substrat (10) und an das zweite Substrat (20) gefügt sind,
ferner aufweisend eine Unterfüllung (50), die einen Spalt (40) zwischen den Halbleiterbauteilen (30) und Substraten (10, 20) zumindest teilweise ausfüllt und
Strukturelemente (60,...,65), die im Spalt (40) angeordnet und zumindest teilweise von der Unterfüllung (50) umgeben sind.

2. Elektronisches Modul (100) nach Anspruch 1, wobei die Strukturelemente (60,...,65) bezüglich der Ebene der Substrate (10,20) bogenförmig ausgestaltet sind.

3. Elektronisches Modul (100) nach Anspruch 1 oder 2, wobei die Strukturelemente (60,...,65) bezüglich der Ebene der Substrate (10,20) höchstens 1/3 eines Ellipsenbogens oder Kreisbogens beschreiben.

4. Elektronisches Modul (100) nach einem der vorhergehenden Ansprüche, aufweisend zumindest zwei Paare von bogenförmig ausgestalteten Strukturelementen (60,...,65), deren Krümmung einander entgegengesetzt ist.

5. Elektronisches Modul (100) nach einem der vorhergehenden Ansprüche, wobei zumindest ein Teil der Strukturelemente (60,...,65) zwischen Halbleiterbauteil (30) und einer Kante (22) eines der Substrate (10, 20) angeordnet sind.

6. Elektronisches Modul (100) nach einem der vorhergehenden Ansprüche, wobei pro Halbleiterbauteil (30) mindestens zwei Strukturelemente (60,...,65) angeordnet sind.

7. Elektronisches Modul (100) nach einem der vorhergehenden Ansprüche, wobei zumindest ein Strukturelement (60,...,65), das eine gerade Form aufweist, in einem Winkel von 30° bis 60° bezüglich einer Ecke (33) eines Halbleiterbauteils (30) angeordnet ist.

8. Elektronisches Modul (100) nach einem der vorhergehenden Ansprüche, wobei zumindest ein Strukturelement (60,...,65), das eine gerade Form aufweist, in einem Winkel von 30° bis 60° bezüglich einer Ecke (33) eines Halbleiterbauteils (30) und einer weiteren Ecke (33) eines weiteren Halbleiterbauteils (30) angeordnet ist.

9. Elektronisches Modul (100) nach einem der vorhergehenden Ansprüche, wobei zumindest ein Strukturelement (60,...,65) zwischen zumindest zwei Halbleiterbauteilen (30) angeordnet ist.

10. Elektronisches Modul (100) nach einem der vorhergehenden Ansprüche, wobei die Strukturelemente (60,...,65) als Metallisierung oder Lötstopplackausformung eines der Substrate (10,20) ausgebildet sind.

11. Elektronisches Modul (100) nach einem der vorhergehenden Ansprüche, wobei die Strukturelemente (60,...,65) als Formteil ausgebildet sind.

12. Elektronisches Modul (100) nach einem der vorhergehenden Ansprüche, wobei die Strukturelemente (60,...,65) aus einem Isolationsmaterial ausgebildet sind.

13. Elektronisches Modul (100) nach einem der vorhergehenden Ansprüche, wobei die Strukturelemente (60,...,65) aus einem Damm-Material ausgebildet sind.

14. Verfahren zum Einbringen einer Unterfüllung (50) in einen Spalt (40) eines elektronischen Moduls (100) nach einem der vorhergehenden Ansprüche, wobei die Unterfüllung (50) in flüssiger Form an einer Kante (22) oder Ecke (23) eines der Substrate (10,20) eingebracht wird.

15. Verfahren zum Einbringen einer Unterfüllung (50) in einen Spalt (40) eines elektronischen Moduls (100) nach Anspruch 13, wobei die Unterfüllung (50) in flüssiger Form an einer Kante (22) oder Ecke (23) eines der Substrate (10,20) eingebracht wird, die den Strukturelementen (60,...,65) gegenüber liegt.
